# EUROPEAN PATENT SPECIFICATION

(11) **EP 0 721 242 B1**
(45) Date of publication and mention of the grant of the patent: **06.03.2002**
(21) Application number: 95401164.9
(22) Date of filing: 19.05.1995
(51) Int. Cl.: H01T 4/12

(54) **Process of manufacturing a surge absorber**
Herstellungsverfahren eines Überspannungsableiters
Méthode de fabrication d'un dérivateur de surtension

(30) Priority: 06.01.1995 CN 95101101
(43) Date of publication of application: 10.07.1996
(73) Proprietor: Yang, Binglin, Shinjuku-ku, Tokyo (JP)
(72) Inventor: Yang, Binglin, Shinjuku-ku, Tokyo (JP)
(74) Representative: Hirsch, Marc-Roger

(56) References cited:
- DE-A- 4 337 928
- GB-A- 967 563
- US-A- 4 727 350

## Description

### Field of The Invention

The present invention relates to a process of manufacturing an electronic device; and, more particularly, to a process of manufacturing a surge absorber.

### Background of The Invention

Stray waves or electrostatic disturbances are inveterate foes to modern electronic apparatus, among various surges, even the intrusion of high voltage pulse waves may cause erroneous operations of semiconductor devices of the electronic apparatus, or even causing damages of the semiconductors and the apparatus themselves. The above-mentioned technical problems can be solved by the use of surge absorbers.

The known surge absorber is constituted by a structure of a conductive film partitioned by micro grooves. The switching voltage of such surge absorber can not be selected freely, therefore the application of which is severely limited. US Patent No. 4,727,350 has disclosed a surge absorber comprising a cylindrical tube core covered with a conductive film, intersecting micro grooves and formed in said conductive film, and sealed in an outer glass envelope. DE-A-4 337 928 describes a surge absorber comprising a housing, electrode bars, a chamber including an inert gas under reduced pressure and a silicon dice. The silicon dice comprises rectangular parallelepiped protrusions. The document discloses further a process to manufacture such a surge absorber and comprising the step of forming a thin layer (0,5 to 3µm in thickness) of non-conductive material by a CVD method. The application field of the absorbers of such structure can be extended. However, it is relatively difficult to fabricate such structure, and the volume of which is bulky, especially, the operating speed is slow and the stability and durability are poor, thereby, it can not meet the practical requirements.

### Summary of The Invention

In order to overcome the drawbacks of the prior art, it is, therefore, an object of the present invention to provide a novel surge absorber having simple structure, small size, better performance and quick response.

The object of the present invention is achieved by the following technical scheme:

The present invention relates to a process for manufacturing a surge absorber comprising a housing, electrode bars, leads or terminals connected to the electrode bars, an air chamber, a tube core provided between the electrode bars, the tube core is constituted by at least a layer of conductive material and at least a layer of non-conductive material, the process comprising
- forming said layer of non-conductive material by a lamination or a thick film process,
- filling said air chamber with argon or mixture of argon and other inert gases or nitrogen, or SF6,
wherein the spark-over voltage of the absorber is 80 V to 3600 V or higher.

In one embodiment, the process comprises further the step of forming said tube core as an integrated body by sequentially overlapping a plurality of layers of conductive and non-conductive materials.

In another embodiment, the process comprises the step of forming said tube core as an irregular tube core by arbitrarily overlapping at least two or more tube cores constituted by a layer of conductive material and a layer of non-conductive material.

In another embodiment, the process of the present invention comprises the step of forming a tube core as an integrated body constituted by non-sequentially overlapping a plurality of layers of conductive and non-conductive materials.

The process comprising further the step of forming said tube core as a stepped structure or a tower-like structure. The material of conductive layer includes monocrystalline silicon, hard metals or metallic alloys. The material of non-conductive layer includes ceramic, glass, or mixture of ceramic and glass.

The housing of the absorber, obtained by the process of the present invention, is a glass sealed or plastic sealed envelope. The content of argon in the mixture of argon and other inert gases is greater than or equal to 3%.

The surge absorber comprises a housing, electrode bars, leads or terminals connected to the electrode bars, and an air chamber, a tube core constituted by a layer of conductive material and a layer of non-conductive material is provided between said electrode bars, and the gases injected into said air chamber include argon, or mixture of argon with one or more other inert gases such as helium, neon, krypton, xenon, and radon, or SF₆, wherein the spark-over voltage of the absorber is from 80 volts to 3600 volts or higher, and the surge absorbing time is less than 0.000001 sec (10⁻⁶ sec). The tube core can be constituted by at least one layer of non-conductive material. Furthermore, the tube core can be an integrated body constituted by sequentially laminating a plurality of layers of conductive material and non-conductive material, or an integrated body constituted by non-sequentially laminating a plurality of layers of conductive material and non-conductive material.

The tube core described above can be cubic, cylindrical, and preferably stepped or tower-like.

In the surge absorber, said tube core can be an irregular tube core consisting of at least two mutually overlapped tube cores constituted by laminating a layer of conductive material and a layer of non-conductive material.

The material constituting the non-conductive layer of said tube core includes ceramic, or glass, or mixture of ceramic and glass. The material of said conductive layer includes mono-crystalline silicon (P-type, N-type or mixed N- and P-type), hard metal such as tungsten, copper and aluminium, or metallic alloy such as stainless steel and duralumin.

The housing of the surge absorber can be an envelope sealed with glass or plastic.

The content of argon in said mixture of gases is equal to or greater than 3%.

Said absorber can be widely used in highly complicated electronic technical circuitries, such as those used as important elements for resetting in electronic computers of large memory capacity and high operation speed. The effects on the electronic apparatus due to surge waves generated by the frequent on/off blinking of the display of computer or other electronic apparatus can be completely resolved.

In addition, it can also be used in apparatus connected by telephone lines, such as telephone set, radio, facsimile, modem and program controlled telephone exchanger; in apparatus connected to antenna and signal lines such as amplifier, tape recorder, vehicle radio, radio transceiver, signal lines of sensors, and apparatus necessary for electrostatic presention such as display and monitor, as well as electric appliance and computer controlled electronic products. It also functions as overvoltage protection. It is an efficient electronic device for resolving the hazardous results caused by static electricity.

### Brief Description of The Drawings

Fig. 1 is a structural diagram of a surge absorber obtained by the process according to an embodiment of the present invention;
Fig. 2 is a structural diagram of a surge absorber obtained by the process according to another embodiment of the present invention;
Fig. 3 is a structural diagram of the tube core of the surge absorber obtained by the process of the present invention;
Fig. 4 is another structural diagram of the tube core of the surge absorber obtained by the process of the present invention;
Fig. 5 is yet another structural diagram of the tube core of the surge absorber obtained by the process of the present invention;
Fig. 6 is still another structural diagram of the tube core of the surge absorber obtained by the process of the present invention;
Fig. 7 is still another structural diagram of the tube core of the surge absorber obtained by the process of the present invention;
Fig. 8 is still another structural diagram of the tube core of the surge absorber obtained by the process of the present invention;
Fig. 9 is yet still another structural diagram of the tube core of the surge absorber obtained by the process of the present invention; and
Fig. 10 is yet still another structural diagram of the tube core of the surge absorber obtained by the process of the present invention.

### Detailed Description of The Preferred Embodiments

The present invention will now be described with reference to the accompanying drawings and the embodiments.

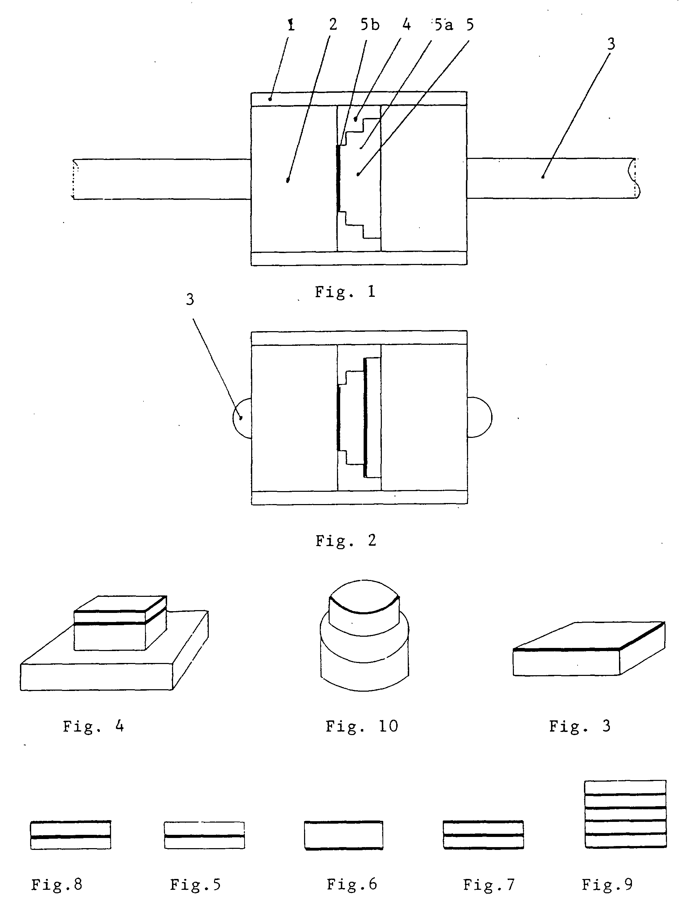

Referring to Fig. 1, a surge absorber obtained by the process of the present invention comprises a housing which is normally a glass envelope 1, electrode bars 2, such as Dumet electrode bars, two leads 3 connected to the electrode bars, or two leadless terminals 3 (referring to Fig.3); a tube core 5 positioned between said electrode bars and connected to the end of one of said electrode bars, the tube core can be cubic or cylindrical (see Fig. 10) and preferably of a stepped structure having a relatively wide lower step and a relatively narrow upper step, or it can be of a tower-like structure. The lower layer of the tube core is a layer of conductive material 5a, such as tungsten, the upper layer of the tube core is a layer of non-conductive material 5b, such as ceramic. In other words, a layer of non-conductive material 5b is disposed on the top suface of the tower-like conductive material 5a. In the sealed housing, an air chamber 4 filled with a gas, such as an inert gas and preferably argon, is formed between the two electrode bars.

The surge absorber obtained by the process of the present invention is a diode capable of efficiently absorbing high voltage spray waves and surge pulses, which is manufactured by the use of the principle of converting electrical energy into photo energy to consume and absorb electrical energy. The reactive characteristic of this absorber is inherently different from that of the LED. The light emission of this absorber is instantaneous, while the light emitting phenomenon of the light emitting diode (LED) or discharge tube gradually turns weak from high intensity to extinction.

The inventor discovered that the larger the surface area of the tube core and the volume of the air chamber, the higher the speed of electro-photo energy convertion. The tube core of the surge absorber obtained by the process of the present invention employs tube core structures specific to the present invention, such as stepped or tower-like structure, and irregular overlapped structure, which can be a connection of a plurality of cubes or cylinders of stepwise reduced sizes. Such structures greatly increase the contact area of the conductive material layer 5a with the gas inside the air chamber, thereby the speed of the conversion from electric to photo energy can be increased. This conversion speed or surge absorbing speed is directly related to the technical performance of the absorber of the present invention.

In comparison with the surge absorber described in the above-mentioned US Patent No. 4,727,350, the absorber obtained by the process of the present invention has the advantages of a long working life and greatly increased durability, such that the failure rate of the application in electrical apparatus is greatly reduced.

In the present invention, the manufacture of the tube core with a layer of conductive material and a layer of non-conductive material (see Fig. 3) is not a unique and limiting implementation. The tube core obtained by the process of the present invention can be an arbitrarily laminated multilayer structure of at least one layer of conductive material and at least one layer of non-conductive material. For example, these layers can be laminated in the order of: non-conductive layer, conductive layer, non-conductive layer and conductive layer (refer to the stepped structure shown in Fig. 4); or conductive layer, non-conductive layer and conductive layer (see Fig. 5); or non-conductive layer, conductive layer and non-conductive layer (see Fig. 6); or non-conductive, conductive, non-conductive, conductive and non-conductive layers (see Fig. 7); or non-conductive, conductive, non-conductive, and conductive layers (see Fig. 8); or the structure shown in Fig. 8, etc.. It can be seen that both the order of lamination and the number of the laminated layers are not limited.

The shape of the laminated tube core described above can be cubic, cylindrical, convex, stepped structure, or tower-like structure.

In the present invention, the tube core can be prepared by utilizing the thick film process known to those skilled in the art.

Generally, the thickness of the layers of conductive and non-conductive materials in the tube core is not limited, and can be determined in accordance with the spark-over voltage, surge current capacity and required working life, sometimes, the thickness of the conductive layer can be greater than that of the non-conductive layer, and sometimes, vice versa.

As described above, in the surge absorber obtained by the process of the present invention, said tube core can be made of an irregular tube core by arbitrarily overlapping two or more tube cores constituted by a layer of conductive material and a layer of non-conductive material. This overlapping is fulfilled in the manufacture of the surge absorber of the present invention, in practice, at least two chips each constituted by a layer of conductive material and a layer of non-conductive material are selected to be placed into the tube housing such that these two or more chips are irregularly contacted with each other, thereby forming a tube core without fixed shape, but the surfaces of both the conductive and non-conductive layers of the finally obtained tube core should be normal to the axis between the two electrode bars.

### Example 1

Glass diode envelope of internationally common DO-34 type, with inner diameter of about 0.66 mm, was selected, and the tube core obtained by the process of the present invention shown in Fig. 3 was employed, the size of which was adaptive to the inner diameter of the DO-34 type, i.e. the diameter of the bottom of the tube core or the diagonal of the quadrilateral was about 0.66 mm, the conductive layer material on the bottom of the tube core was monocrystalline silicon of 0.20 mm in thickness, and the top layer was ceramic of 0.04 mm in thickness, the surge absorber (called tube 1) was sealed by sintering in the state of filled with argon, which was similar to the method for preparation of common glass sealed diode known to those skilled in the art.

The air chamber is filled with pure argon.

### Example 2

Glass diode envelope of internationally common DO-35 type, with inner diameter of about 0.76 mm, was selected, a surge absorber was manufactured there from with the method similar to that of Example 1, except that the shape of the tube core inside this surge absorber was the structure shown in Fig. 1, the materials of the conductive and non-conductive layers were tungsten and glass, respectively, the resultant surge absorber was called tube 2. The thickness of the conductive layer of this absorber was 0.28 mm, and that of the non-conductive layer was 0.08 mm.

The air chamber was filled with a mixture of argon and nitrogen, and the content of argon is 30%.

### Example 3

A surge absorber was manufactured with the same method as that of Example 1, except that the shape of the tube core of this surge absorber was the structure shown in Fig. 8, the materials of the conductive and non-conductive layers were tungsten and ceramic, respectively, the surge absorber manufactured was called tube 3. The tube core of this absorber was constituted by laminating two structures as shown in Fig. 3.

The air chamber was filled with a mixture of argon and helium, and the content of argon was 70%.

### Example 4

Glass diode envelope of common DO-41 type was selected, the inner diameter of which was 1.53 mm and the diameter of the leads was 0.5 mm (Φ0.5mm), a surge absorber was manufactured with the same method as that of Example 1, except that the shape of the tube core inside this surge absorber was the structure shown in Fig. 5, the materials of the conductive and non-conductive layers were monocrystalline silicon and ceramic, respectively, the surge absorber thus obtained was called tube 4. The thickness of the conductive layer of this surge absorber was 0.20 mm, and that of the non-conductive layer was 0.28 mm. The size of the tube core of this absorber was 1.0 x 1.0 mm.

The air chamber was filled with a mixture of argon and radon, and the content of argon was 90%.

### Example 5

Glass diode envelope of external diameter 2.6 mm (Φ2.6) was selected, the inner diameter of which was about 1.53 mm and the diameter of leads was 0.5 mm (Φ0.5mm), a surge absorber was manufactured with the same method as that of Example 1, except that the shape of the tube core inside this surge absorber was the structure shown in Fig. 6, i.e., an integrated tube core formed by overlapping the tube cores shown in Fig. 3. However, the material of the conductive layer was monocrystalline silicon, and that of the non-conductive layer was glass, the surge absorber thus obtained was called tube 5.

The air chamber was filled with pure argon.

### Example 6

Glass diode envelope of external diameter 3.1 mm (Φ 3.1) was selected, the inner diameter of which was about 1.75 mm, and the diameter of the leads was 0.5 mm (Φ0.5mm), a surge absorber was manufactured with the same method as that of Example 1, except that the shape of the tube core inside this surge absorber was the structure shown in Fig. 9, the material of the conductive layer is tungsten, and that of the non-conductive layer was glass, the surge absorber thus obtained was called tube 6.

The air chamber was filled with SF₆, and the purity there of was 99%.

### Experiment 1

In the following experiments, the surge absorbers obtained in the above-mentioned Example 1 to Example 6 (tube 1 to tube 6) were respectively tested with the method known to those skilled in the art, the test values selected were the technical parameters recorded in the following Table 1 and Table 2, such as spark-over voltage, insulation resistance, electrostatic capacitance, surge life, and surge current capacity.

Their technical performances and results were listed in Table 1 and Table 2, respectively.

In this experiment, said current and voltage values were measured by a voltage-withstand apparatus made of a "variable DC fixed voltage fixed current power supply" (METRONIX, Model HSV2K-100, Power supplies 0-2 KV, 100 mA). Said resistance values were measured by a Component Tester (ADEX Corporation, Model 1-808-BTL).

**Table 1**

| | Spark-over Voltage Vs(V) | Insulation Resistance (IR) Ω | Electrostatic Capacitance C (pF) | Surge life Test ESD:500pF-5000-10000V times |
|---|---|---|---|---|
| Tube 1 | 80 | >100M/DC50V | < 0.6 | > 300 |
| Tube 2 | 206 | >100M/DC100V | < 0.6 | > 300 |
| Tube 3 | 315 | >100M/DC100V | < 0.6 | > 300 |

**Table 2**

| | Spark-over Voltage Vs(V) | Insulation Resistance Life (IR) Ω | Electrostatic Capacitance C (pF) | Surge Current Capacity (8x20) µ sec | Surge Life Test DOC cyclc * |
|---|---|---|---|---|---|
| Tube 4 | 560 | >100M/DC250V | < 0.6 | 500 A | DOC 1 cylce |
| Tube 5 | 1000 | >100M/DC250V | < 1 | 2000 A | (8x20) µsec-100A 300 times |
| Tube 6 | 3668 | >100M/DC250V | < 1 | 2000 A | (8x20) µsec-100A 300 times |

| | | | | | |
|---|---|---|---|---|---|
| Remarks: *DOC cycle: (10X1000) µsec, (100x1000) µsec-1KV 12 times, respectively. | | | | | |

### Experiment 2

The stabilities of the surge absorbers obtained by the process of the present invention obtained in Examples 1-6 were tested with the means and method known to those skilled in the art, wherein the technical parameters employed were: working life, cold hardiness, heat-resistance, humidity-resistance, temperature adaptation, the results were shown in Table 3.

**Table 3**

| Item | Test Method | Result |
|---|---|---|
| Working Life | Charge the 1500pF capacitor by applying 10KV DC voltage, contact discharge with a 2K resistor, 10 sec period, 200 times. | The measurement vary within ±30% before and after the test |
| | | |
| Cold Hardiness | Placed in -40°C for 1000hr, then measured after being placed in room temperature for 2 hr. | Same values before and after test |
| | | |
| Heat-resistance | Placed in 125°C for 1000 hr, then measured after being placed in room temperature for 2 hr. | Same values before and after test |
| | | |
| Humidity-resistance | Placed in 45°C and relative humidity of 90-95% for 1000 hr, then measured after being placed in room temperature for 2 hr. | Same values before and after test |
| | | |
| Temperaure Adaptation | Repeating -40°C (30min)--room temperature (2min)--125°C(300min) for more than 10 times, then measured after being placed in room temperature for 2 hr. | Same values before and after test |

After having tested the six types of surge absorbers with the above-mentioned methods, all the variations of the spark-over voltages, insulation resistances, electrostatic capacitances, surge lives and surge capacities of these surge absorbers as listed in Table 1 and Table 2 were within the prescribed values of the above Tables.

## Claims

1. A process for manufacturing a surge absorber comprising a housing (1); electrode bars (2); leads or terminals (3) connected to the electrode bars (2); an air chamber (4), a tube core (5) provided between the electrode bars, the tube core is constituted by at least a layer of conductive material (5a) and at least a layer of non-conductive material (5b), the process comprising
- forming said layer of non-conductive material (5b) by a lamination or a thick film process,
- filling said air chamber (4) with argon or mixture of argon and other inert gases or nitrogen, or SF6, and
wherein the spark-over voltage of the absorber is 80 V to 3600 V or higher.

2. The process of claim 1, comprising forming said tube core as an integrated body by sequentially overlapping a plurality of layers of conductive and non-conductive materials.

3. The process of claim 1, comprising forming said tube core as an irregular tube core by arbitrarily overlapping at least two or more tube cores constituted by a layer of conductive material and a layer of non-conductive material.

4. The process of claim 1, comprising forming said tube core as an integrated body constituted by non-sequentially overlapping a plurality of layers of conductive and non-conductive materials.

5. The process of any one of claims 1 to 4, comprising forming said tube core as a stepped structure or a tower-like structure.

6. The process of any one of claims 1 to 5, **characterized in that** said material of conductive layer includes monocrystalline silicon, hard metals or metallic alloys.

7. The process of any one of claims 1 to 6, **characterized in that** said material of non-conductive layer includes ceramic, glass, or mixture of ceramic and glass.

8. The process of any one of claims 1 to 7, **characterized in that** said housing of the absorber is a glass sealed or plastic sealed envelope.

9. The process of any one of claims 1 to 8, **characterized in that** said content of argon in the mixture of argon and other inert gases is greater than or equal to 3%.

## Patentansprüche

1. Ein Verfahren zur Herstellung eines Überspannungsleiters, umfassend ein Gehäuse (1); Elektrodenstäbe (2); mit den Elektrodenstäben (2) verbundene Leiter oder Pole (3); eine Luftkammer (4), einen zwischen den Elektrodenstäben angeordneten Rohrkern (5), welcher aus mindestens einer Schicht von leitendem Material (5a) sowie aus mindestens einer Schicht von nichtleitendem Material (5b) besteht, wobei das Verfahren umfasst:
- Bildung der mindestens einen Schicht nichtleitendem Material (5b) durch Laminierung oder einem Dickfilmprozess ;
- Füllung der Luftkammer (4) mit Argon oder einer Mischung aus Argon und anderen inerten Gasen oder Stickstoff, oder SF₆ ; und
in welchem die Überschlagsspannung des Überspannungsleiters 80 bis 3600V oder mehr beträgt.

2. Das Verfahren gemäß Anspruch 1, umfassend die Bildung des Rohrkems in einem Stück durch sukzessives Aufeinanderlegen einer Mehrzahl von leitenden und nichtleitenden Materialien.

3. Das Verfahren gemäß Anspruch 1, umfassend die Bildung des Rohrkerns als unregelmäßigen Rohrkern durch willkürliches Aufeinanderlegen von mindestens zwei oder mehr Rohrkernen, welche aus einer Schicht von leitendem Material und aus einer Schicht von nichtleitendem Material bestehen.

4. Das Verfahren gemäß Anspruch 1, umfassend die Bildung des Rohrkerns in einem Stück, bestehend aus nicht sukzessivem Aufeinanderlegen einer Mehrzahl von leitenden und nichtleitenden Materialien.

5. Das Verfahren gemäß mindestens einem der Ansprüche 1 bis 4, umfassend die Bildung des Rohrkerns als gestufte Struktur oder als getürmte Struktur.

6. Das Verfahren gemäß mindestens einem der Ansprüche 1 bis 5, **gekennzeichnet dadurch, dass** das Material der leitenden Schichten monokristallines Silizium, Hartmetalle oder metallische Legierungen umfasst.

7. Das Verfahren gemäß mindestens einem der Ansprüche 1 bis 6, **gekennzeichnet dadurch, dass** das Material der nichtleitenden Schichten Keramik, Glas oder eine Mischung von Keramik und Glas umfasst.

8. Das Verfahren gemäß mindestens einem der Ansprüche 1 bis 7, **gekennzeichnet dadurch, dass** das Gehäuse des Überspannungsleiters eine mit Glas oder Plastik verkapselte Umhüllung ist.

9. Das Verfahren gemäß mindestens einem der Ansprüche 1 bis 8, **gekennzeichnet dadurch, dass** der Gehalt an Argon der Mischung aus Argon und anderen inerten Gasen mindestens 3% beträgt.

## Revendications

1. Un procédé de fabrication d'un coupe-circuit de surtension comprenant un boîtier (1) ; des électrodes sous forme de barres (2) ; des bornes ou des conducteurs (3) reliés aux électrodes sous forme de barres (2) ; une chambre à air (4) ; un noyau sous forme de tube (5) disposé entre les électrodes sous forme de barres, le noyau sous forme de tube étant constitué d'au moins une couche d'un matériau conducteur (5a) et d'au moins une couche d'un matériau non conducteur (5b), le procédé comprenant :
- la formation de ladite couche de matériau non conducteur (5b) par un procédé de stratification ou un procédé en couche épaisse ;
- le remplissage de ladite chambre à air (4) avec de l'argon ou un mélange d'argon ou d'autres gaz inertes ou de l'azote ou du SF6 ; et
- dans lequel la tension d'amorçage du coupe-circuit est entre 80 V et 3600 V ou plus.

2. Le procédé selon la revendication 1, comprenant la formation dudit noyau sous forme de tube comme corps intégré par recouvrement mutuel séquentiel d'une pluralité de couches de matériaux conducteurs et non conducteurs.

3. Le procédé selon la revendication 1, comprenant la formation dudit noyau sous forme de tube comme un noyau sous forme de tube irrégulier par un chevauchement aléatoire d'au moins deux, ou plus de deux, noyaux sous forme de tube constitués d'une couche de matériau conducteur et d'une couche de matériau non conducteur.

4. Le procédé selon la revendication 1, comprenant la formation dudit noyau sous forme de tube en tant que corps intégré constitué par le chevauchement non séquentiel d'une pluralité de couches de matériau conducteur et non conducteur.

5. Le procédé selon l'une quelconque des revendications 1 à 4, comprenant la formation dudit noyau sous forme de tube en tant que structure étagée ou structure sous forme de tour.

6. Le procédé selon l'une quelconque des revendications 1 à 5, **caractérisé en ce que** ledit matériau de la couche conductrice comprend du silicium mono-cristallin, des métaux durs ou des alliages métalliques.

7. Le procédé selon l'une quelconque des revendications 1 à 6, **caractérisé en ce que** ledit matériau de la couche non conductrice comprend de la céramique, du verre ou un mélange de céramique et de verre.

8. Le procédé selon l'une quelconque des revendications 1 à 7, **caractérisé en ce que** ledit boîtier dudit court-circuit est une enveloppe en verre scellée ou en matière plastique scellée.

9. Le procédé selon l'une quelconque des revendications 1 à 8, **caractérisé en ce que** ledit contenu d'argon dans le mélange d'argon et d'autres gaz inertes est supérieur ou égal à 3 %.
